Europäisches Patentamt

European Patent Office

Office européen des brevets

(11) Publication number: **0 438 602 A1**

## EUROPEAN PATENT APPLICATION
### published in accordance with Art. 158(3) EPC

(21) Application number: 90912053.7

(22) Date of filing: 09.08.90

(86) International application number:
PCT/JP90/01019

(87) International publication number:
WO 91/02294 (21.02.91 91/05)

(51) Int. Cl.⁵: **G03F 1/14**

(30) Priority: 10.08.89 JP 207503/89

(43) Date of publication of application:
31.07.91 Bulletin 91/31

(84) Designated Contracting States:
CH DE GB IT LI

(71) Applicant: DAICEL CHEMICAL INDUSTRIES,
LTD.
1, Teppo-cho Sakai-shi
Osaka 590(JP)

(72) Inventor: MIYATA Akihiro 940, Shinzaike
Aboshi-ku, Himeji-shi
Hyogo 671-12(JP)
Inventor: TAKAHASHI Shigeyuki
863-6, Tadera Himeji-shi
Hyogo 670(JP)

(74) Representative: Patentanwälte Grünecker,
Kinkeldey, Stockmair & Partner
Maximilianstrasse 58
W-8000 München 22(DE)

(54) **DUST-PREVENTING FILM.**

(57) A dust-preventing film comprising a pellicle frame (2), a pellicle film (1) spread across one end surface thereof, and an adhesive layer (5) that includes a hot melt-type adhesive (4) provided on the other end surfaces. The film is attached to a photo-mask (6) or a reticule to prevent foreign matters from adhering to the circuit patterns (7).

Fig. 1

EP 0 438 602 A1

## [FIELD OF INDUSTRIAL APPLICATION]

The present invention relates to a dustproof film (hereinafter referred to as "pellicle") used for the purpose of preventing foreign material, such as dust, from adhering to a photomask, a reticle or the like (hereinafter generically referred to as "mask") in the photolithographic step in a process for manufacturing semiconductors such as IC and LSI.

[Prior Art]

The projection printing technique is employed in the photolithographic step in a process for manufacturing ICs, LSIs, etc. This technique comprises projecting a circuit pattern formed on a mask through the use of a light beam on a wafer previously coated with a resist and conducting photocuring or photodeterioration of the resist at a portion corresponding to the pattern. When dust (or contaminant) is present in the circuit pattern on the mask, the dust as well is unfavorably projected and exposed on the wafer, which is causative of defectives.

In order to solve this problem, a proposal has been made on a process wherein a pellicle made of a thin resin film is provided on the mask (see Japanese Patent Publication No. 28716/1979).

The pellicle generally comprises an aluminum frame (hereinafter referred to as "pellicle frame") wherein a transparent thin film of nitrocellulose or the like is provided in a stretched state on one thereof and a double-coated pressure-sensitive adhesive tape is provided on the other side thereof. The pellicle is mounted on a mask through the utilization of the double-coated pressure-sensitive adhesive tape.

The mounting of the pellicle on the mask prevents foreign materials from adhering to the mask. Further, even if the foreign materials should adhere to the film, they would be present outside the focal point during exposure and therefore projected in an out-of-focus state, so that no defectives will occur.

The present inventors recognized the presence of foreign matter in a test which comprises mounting a pellicle comprising a pellicle frame having a thin nitrocellulose film free from adherent foreign matter provided in a stretched state on one side of the frame and a double-coated pressure-sensitive adhesive tape prepared by coating a foamed polymer tape as a base material with a pressure-sensitive adhesive on both surfaces thereof on the other side of the frame through the utilization of the pressure-sensitive adhesive, blowing the air against the outside of the thin film with an air gun, taking off the pellicle, and checking the surface of the mask for foreign matter.

In order to solve the above-described problem, the inside of the pellicle was scrutinized. As a result, it was found that the cross section of the foamed polymer tape as the base material of the double-coated pressure-sensitive adhesive tape was porous and had minute unevennesses and the pores contained foreign matter, which came out of the pores to adhere to the mask or the like when subjected to vibration or impact, thus causing dusting.

On the other hand, from the viewpoint of hermetically sticking the pellicle to the mask, it is advantageous that the pressure-sensitive adhesive is elastic. At the present time, the thickness of the pressure-sensitive adhesive of the double-coated pressure-sensitive adhesive tape used for the purpose of sticking the pellicle to the mask is 50 to 70 $\mu$m in terms of the total thickness of both surfaces.

For this reason, a pellicle which neither brings about dusting even when subjected to vibration or impact nor contaminates the mask and has elasticity in the pressure-sensitive adhesive layer has been desired in the art.

[Brief Description of the Drawings]

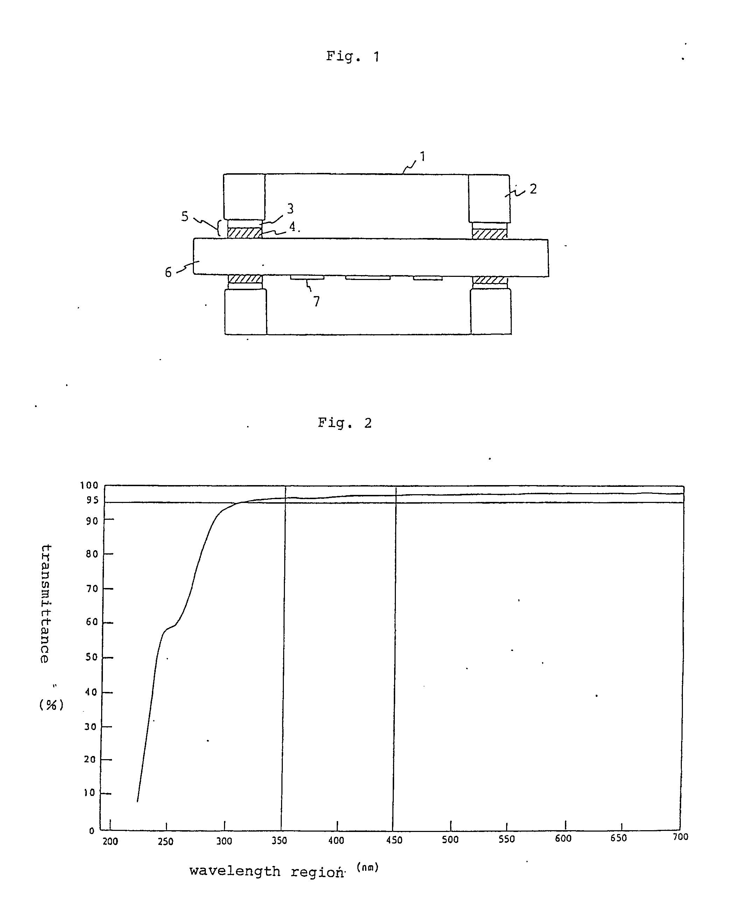

Fig. 1 is a cross-sectional view of an example of use of the pellicle of the present invention; and Fig. 2 is a diagram showing the transmittance of a hot melt pressure-sensitive adhesive based on butyl rubber used in Example 1 in the wavelength region of 230 to 700 nm.

1: pellicle film          2: pellicle frame

3: adhesive              4: pressure-sensitive adhesive

5: pressure-sensitive adhesive layer      6: mask

7: circuit pattern

[Disclosure of Invention]

The present inventors have made intensive studies with a view to solving the above-described problems and, as a result, have found that a pellicle which utilizes the elasticity of the pressure-sensitive adhesive through an increase in the thickness of the viscoelastic pressure-sensitive adhesive without utilizing the elasticity of the base material of the pressure-sensitive tape can be hermetically stuck to the mask and provide a nondusting pellicle free from the occurrence of foreign matter, material or substance, which has led to completion of the invention.

Accordingly, the present invention provides a pellicle (dustproof film) used for preventing, through mounting on a photomask, a reticle or the like, foreign matter from adhering to a circuit pattern, characterized by comprising a pellicle frame, a pellicle film provided on one side of the frame and a hot melt pressure-sensitive adhesive provided on the other side of the frame.

The hot melt pressure-sensitive adhesive used in the present invention is free from any solvent, so that drying is unnecessary after application of the adhesive, which renders the adhesive used in the present invention advantageous from the viewpoint of the manufacturing process. Further, there occurs no problem of the solvent remaining in the pressure-sensitive adhesive. If the solvent remains in the adhesive, it will evaporate little by little after sticking of the pellicle to the photomask. The evaporated solvent vapor stays within a closed space defined by the photomask, pellicle frame and thin nitrocellulose film and swells the nitrocellulose film upon contact therewith. The swelling causes the film thickness to change. When swelling further advances, the stretched state of the nitrocellulose film on the pellicle frame is lost, so that the film creases or sags. The variation in the thickness of the nitrocellulose film provided in a stretched state on the pellicle frame unfavorably brings about a variation in the transmittance at a particular wavelength. Further, the use of the thin film in a creased or sagged state adversely affects the optical path length or refraction of light during exposure.

In the present invention, hot melt pressure-sensitive adhesives commonly used in the art, that is, those mainly composed of ethylene-vinyl acetate copolymer, acrylic copolymer, butyral resin, polyamide resin, natural rubber or synthetic rubber, are used as the hot melt pressure-sensitive adhesive. Further, it is also possible to use, as a tackifier, rosin and its derivatives, terpene resins, petroleum resins, coumaroneindene resins, polystyrene resins, polybutyral resins, polyolefin resins, rubbers, polyamide resins, polyisoprene resins, phenolic resins, and mixtures of these resins. Further, it is also possible to add waxes, plasticizers, fillers, antioxidants, etc. A pressure-sensitive adhesive having an absorbance in a wavelength region of 350 to 450 nm of 5 % or less is particularly preferred as the hot melt pressure-sensitive adhesive used in the present invention. This is because large absorption of light causes the pressure-sensitive adhesive to deteriorate or decompose with time, so that the pressure-sensitive adhesive becomes causative of dusting.

The adhesion property of the pressure-sensitive adhesive is preferably such that the adhesion to the pellicle frame is larger than the adhesion to the mask. When the adhesion to the mask is larger than the adhesion to the pellicle frame, the pressure-sensitive adhesive layer remains on the mask and stains it when the pellicle is taken off from the mask. Examples of the method of enhancing the adhesion of the pressure-sensitive adhesive to the pellicle frame include one which comprises applying an adhesive to the other side of the pellicle frame and then applying a hot melt pressure-sensitive adhesive, one which comprises sticking a single-coated pressure-sensitive adhesive tape on the other side of the pellicle frame and then applying a hot melt pressure-sensitive adhesive to the section of the single-coated pressure-sensitive adhesive tape and the face on the side to be stuck to the mask or the like, and one which comprises sticking a double-coated pressure-sensitive adhesive tape on the other side of the pellicle frame and then applying a hot melt pressure-sensitive adhesive to the section of the double-coated pressure-sensitive adhesive tape and the face on the side to be stuck to the mask or the like.

Epoxy adhesives, acrylic adhesives, cyanoacrylate adhesives, vinyl adhesives and polyester adhesives are examples of the adhesive usable herein. Pressure-sensitive adhesive tapes comprising as a base material a polyester film, a polypropylene film, a Teflon film or a polyvinyl chloride film and as a pressure-sensitive adhesive an acrylic copolymer pressure-sensitive adhesive, a rubber pressure-sensitive adhesive or an ethylene-vinyl acetate copolymer pressure-sensitive adhesive are usable as the single-coated and double-coated pressure-sensitive adhesive tapes.

The coating width of the above-described adhesives previously applied to the pellicle frame should be less than the width of the pellicle frame. The width of the single-coated or double-coated pressure-sensitive adhesive tape is preferably 40 to 95 %, still preferably 65 to 85 % of the width of the pellicle frame. When this width is less than 40 %, the adhesion to the pellicle frame lowers unfavorably.

The fluidizing temperature of the hot melt pressure-sensitive adhesive used in the present invention is preferably 40 °C or above, still preferably 40 to 180 °C. When the fluidizing temperature is below 40 °C, there is a possibility that the pressure-sensitive adhesive might melt in summer, so that the adhesion retaining power lowers unfavorably. The melt viscosity at 160 °C of the hot melt pressure-sensitive adhesive used in the present invention is preferably 0.5 to 10,000 poise.

In the present invention, examples of the method of applying the hot melt pressure-sensitive adhesive to the pellicle frame include screen printing, spraying, a method wherein use is made of an air gun, and a method wherein use is made of a syringe, among which the method wherein use is made of a syringe is preferred. This method comprises heating a hot melt pressure-sensitive adhesive at 80 to 180 °C, discharging the pressure-sensitive adhesive from a syringe at its tip having an inner diameter of 30 to 90 % of the width of the pellicle frame to apply it to the side of the pellicle frame. The viscosity of the pressure-sensitive adhesive during discharging is preferably 0.5 to 1,000 poise from the viewpoint of smooth discharge of the hot melt pressure-sensitive adhesive from the tip of the syringe. When the viscosity is excessively low, i.e., less than 0.5 poise, the pressure-sensitive adhesive is fluidized and overflows the pellicle frame. On the other hand, when the viscosity exeeds 1,000 poise, it becomes difficult to discharge the pressure-sensitive adhesive from the tip of the syringe, so that the coating work becomes difficult.

The coating width of the hot melt pressure-sensitive adhesive is preferably 30 to 100 % of the width of the pellicle frame. When a pressure-sensitive adhesive tape has been previously stuck to the pellicle frame, the hot melt pressure-sensitive adhesive is preferably applied in a width larger than that of the pressure-sensitive adhesive tape from the viewpoint of preventing dusting.

After the coating of the pellicle frame with the hot melt pressure-sensitive adhesive, it is quite effective in improving the hermetical adhesion of the pellicle to the mask to press the adhesive surface on a smooth and highly releasable face at a temperature of 40 to 100 °C under a low pressure, preferably a pressure of 0.01 to 2.0 kg/cm² for the purpose of leveling the pressure-sensitive adhesive layer. The coating thickness of the hot melt pressure-sensitive adhesive is preferably 0.05 to 2.0 mm, still preferably 0.08 to 1.5 mm. When the thickness is less than 0.05 mm, the hermetical adhesion to the mask is unsatisfactory. On the other hand, when the thickness exceeds 2.0 mm, the height of the pellicle frame should be reduced because there is a limitation on the height of the pellicle, so that there arises a problem on the strength of the pellicle frame. For this reason, the thickness of the pressure-sensitive adhesive layer of the present invention is preferably 0.05 to 2.0 mm.

An example of the use of the pellicle of the present invention is shown in Fig. 1. Two pellicles of the present invention comprising a pressure-sensitive adhesive layer 5 formed by applying an adhesive 3 to one side of a pellicle frame 2 having on the other side thereof a pellicle film 1 provided in a stretched state and further applying a hot melt pressure-sensitive adhesive 4 thereto can be mounted on both sides of a mask 6 having a circuit pattern 7 stuck to both sides thereof, thereby preventing foreign matter such as dust from adhering to the mask.

[Examples ]

The present invention will now be described in more detail by way of the following Examples, though it is not limited to these Examples only.

Example 1

A pellicle prepared by providing a pellicle film in a stretched state on one side of an anodized aluminum frame, applying a hot melt pressure-sensitive adhesive based on butyl rubber to the other side of the frame to form a pressure-sensitive adhesive layer (thickness: 0.09 mm) was stuck to a quartz substrate previously tested on the number of foreign materials and the air was blown against the outside of the pellicle film with an air gun to examine a change in the number of foreign materials having a size of 1 μm or

more on the quartz substrate. The distance between the pellicle film and the air gun was 3 cm, the pneumatic pressure was 3 kg/cm² at the output of the air gun, and the caliber of the air gun was 3 mm. The results are given in Table 1.

A change in the transmittance in the wavelength region of 230 to 700 nm of the butyl rubber hot melt pressure-sensitive adhesive used in the present Example is shown in Fig. 2.

Comparative Example 1

A pellicle prepared by providing a pellicle film in a stretched state on one side of an anodized aluminum frame and sticking to the other side of the frame a double-coated pressure-sensitive adhesive tape comprising a foamed polymer tape (thickness of base material: 0.7 mm, thickness of pressure-sensitive adhesive: 50 μm) as a base material and applied to both sides of the base material an acrylic pressure-sensitive adhesive of solvent type was stuck to a quartz substrate previously tested on the number of foreign materials to examine a change in the number of foreign materials in the same manner as that of Example 1. The results are given in Table 1.

## Table 1

| | pressure-sensitive adhesive layer | Sample No. | Number of foreign materials (pieces) | | Average increase in number of materials (pieces) |
|---|---|---|---|---|---|
| | | | before air blow | after air blow | |
| Ex. 1 | hot melt pressure-sensitive adhesive | 1 | 3 | 3 | 0 |
| | | 2 | 2 | 2 | |
| | | 3 | 4 | 3 | |
| Comp. Ex. 1 | double-coated pressure-sensitive adhesive tape | 10 | 2 | 4 | 3.7 |
| | | 11 | 3 | 8 | |
| | | 12 | 2 | 6 | |

Example 2

A pellicle prepared by providing a pellicle film in a stretched state on one side of an anodized aluminum frame, sticking to the other side of the frame a double-coated pressure-sensitive adhesive tape (thickness of base material: 50 μm, thickness of pressure-sensitive adhesive: 50 μm) and applying a hot melt pressure-sensitive adhesive based on butyl rubber to the section of the double-coated pressure-sensitive adhesive tape and the face on the side to be stuck to the mask to form a pressure-sensitive adhesive layer (thickness: 0.1 mm) was stuck to a quartz substrate previously tested on the number of foreign materials to examine a change in the number of foreign materials in the same manner as that of Example 1. The results were the same as those of Example 1.

Example 3

A pellicle prepared by providing a pellicle film in a stretched state on one side of an anodized aluminum frame, sticking to the other side of the frame a single-coated pressure-sensitive adhesive tape (thickness of pressure-sensitive adhesive: 30 μm, thickness of base material: 40 μm) and applying a hot melt pressure-sensitive adhesive based on butyl rubber to the section of the double-coated pressure-sensitive adhesive tape and the face on the side to be stuck to the mask to form a pressure-sensitive adhesive layer (thickness: 1.6 mm) was stuck to a quartz substrate previously tested on the number of foreign materials to examine a change in the number of foreign materials in the same manner as that of Example 1. The results were the same as those of Example 1.

Example 4

A pellicle prepared by providing a pellicle film in a stretched state on one side of an anodized aluminum frame, applying an adhesive to the other side of the frame and applying an acrylic hot melt adhesive thereto to form a pressure-sensitive adhesive layer was stuck to a quartz substrate previously tested on the number of foreign materials to examine a change in the number of foreign materials in the same manner as that of Example 1. The results were the same as those of Example 1.

Example 5

A pellicle film was provided in a stretched state on one side of an anodized aluminum frame, and an ethylene-vinyl acetate hot melt pressure-sensitive adhesive was applied to the other side of the frame to form a pressure-sensitive adhesive layer (thickness: 0.08 mm). The resultant pellicle was pressed against a highly smooth quartz glass subjected to a releasing treatment and having a surface temperature of 60 °C under a load of 500 g (pressure: 0.06 kg/cm$^2$) with the pressure-sensitive adhesive layer facing downward.

Thereafter, the pellicle was stuck to the quartz substrate, and the adhesion of the pellicle was observed from the side of the quartz substrate. As a result, it has been found that the pressure-sensitive adhesive adhered to the quartz substrate without interruption, i.e., excellent adhesion was obtained.

Example 6

A pellicle prepared in the same manner as that of Example 5 and comprising an aluminum frame, a 0.865-$\mu$m thick nitrocellulose film provided in a stretched state on one side of the aluminum frame and an ethylene-vinyl acetate hot melt pressure-sensitive adhesive applied to the other side of the aluminum frame was stuck to a quartz substrate and allowed to stand at 30 °C for 10 days. Thereafter, the thickness of the nitrocellulose film was measured by the transmission interference method to examine a change in the film thickness. The results are given in Table 2.

The amount of the solvent contained in the ethylene-vinyl acetate hot melt pressure-sensitive adhesive was measured prior to the sticking of the pellicle to the quartz substrate and found to be zero.

Comparative Example 2

A 0.865-$\mu$m thick nitrocellulose film was provided in a stretched state on one side of an anodized aluminum frame, and an acrylic pressure-sensitive adhesive of solvent type (pressure-sensitive adhesive component: 40 % by weight, butyl acetate: 30 % by weight, toluene: 30 % by weight) was applied to the other side of the aluminum frame in a thickness of 0.08 mm. The resultant assembly was dried at 100 °C for 20 sec to form a pressure-sensitive adhesive layer and then allowed to stand at 20 °C for 24 days.

The pellicle was stuck to the quartz substrate in the same manner as that of Example 6, and allowed to stand at 30 °C for 10 days to measure a change in the thickness of the nitrocellulose film. The results are given in Table 2.

The amount of the solvent remaining in the acrylic pressure-sensitive adhesive was measured prior to the sticking of the pellicle to the quartz substrate. As a result, the amounts of butyl acetate and toluene were found to be 4.6 % by weight and 1.3 % by weight, respectively.

EP 0 438 602 A1

Table 2

| | Amount of solvent remaining in pressure sensitive adhesive layer (wt.%) | Results of measurement of film thickness (μm) | | |
|---|---|---|---|---|
| | | film thickness before sticking of pellicle to quartz substrate | film thickness after sticking of pellicle to quartz substrate followed by standing of assembly at 30 °C for 10 days | change in film thickness |
| Ex. 6 | 0 | 0.865 | 0.865 | 0 |
| Comp. Ex. 2 | butyl acetate: 4.6 toluene: 1.3 | 0.865 | 0.889 | +0.024 |

**Claims**

1. A dustproof film used for preventing, through mounting on a photomask, a reticle or the like, foreign matter from adhering to a circuit pattern, characterized by comprising a pellicle frame, a pellicle film provided on one side of the frame and a hot melt pressure-sensitive adhesive layer provided on the other side of the frame.

2. A dustproof film according to claim 1, wherein said pressure-sensitive adhesive layer is one formed by sticking a single-coated pressure-sensitive adhesive tape to the other side of the pellicle frame and then applying a hot melt pressure-sensitive adhesive to a section of the pressure-sensitive adhesive tape and a face on the side to be stuck to a mask or the like.

3. A dustproof film according to claim 1, wherein said pressure-sensitive adhesive layer is one formed by sticking a double-coated pressure-sensitive adhesive tape to the other side of the pellicle frame and then applying a hot melt pressure-sensitive adhesive to a section of the pressure-sensitive adhesive tape and a face on the side to be stuck to a mask or the like.

4. A dustproof film according to claim 1, wherein said pressure-sensitive adhesive layer is one formed by applying an adhesive to the other side of the pellicle frame and then applying a hot melt pressure-sensitive adhesive thereto.

5. A dustproof film according to claim 1, wherein the absorbance of the hot melt pressure-sensitive adhesive in the wavelength region of 350 to 450 nm is 5% or less.

6. A dustproof film according to claim 1, wherein the pressure-sensitive adhesive layer is one formed by pressing the surface of the hot melt pressure-sensitive adhesive against a smooth face at a temperature of 40 to 100 °C under a pressure of 0.01 to 2.0 kg/cm$^2$.

7. A dustproof film according to claim 1, wherein the fuidizing temperature of the hot melt pressure-sensitive adhesive is 40 to 180 °C.

8. A dustproof film according to claim 1, wherein the melt viscosity of the hot melt pressure-sensitive adhesive is 0.5 to 10,000 poise at 160 °C.

7

9. A dustproof film according to claim 1, wherein the adhesion of the pressure-sensitive adhesive layer or the pressure-sensitive adhesive to the pellicle frame is larger than the adhesion to the mask or the like.

Fig. 1

Fig. 2

wavelength region (nm)

# INTERNATIONAL SEARCH REPORT

International Application No PCT/JP90/01019

**I. CLASSIFICATION OF SUBJECT MATTER** (if several classification symbols apply, indicate all) *

According to International Patent Classification (IPC) or to both National Classification and IPC

Int. Cl$^5$     G03F1/14

**II. FIELDS SEARCHED**

| Minimum Documentation Searched [7] | |
|---|---|
| Classification System | Classification Symbols |
| IPC | G03F1/14 |

| Documentation Searched other than Minimum Documentation to the Extent that such Documents are Included in the Fields Searched * | |
|---|---|
| Jitsuyo Shinan Koho | 1953 – 1990 |
| Kokai Jitsuyo Shinan Koho | 1971 – 1990 |

**III. DOCUMENTS CONSIDERED TO BE RELEVANT [9]**

| Category * | Citation of Document, [11] with indication, where appropriate, of the relevant passages [12] | Relevant to Claim No. [13] |
|---|---|---|
| A | JP, A, 60-75835 (Hitachi, Ltd.), 30 April 1985 (30. 04. 85), (Family: none) | 1 – 9 |
| A | JP, A, 61-53601 (Asahi Chemical Industry Co., Ltd.), 17 March 1986 (17. 03. 86), (Family: none) | 1 – 9 |
| A | JP, A, 63-104058 (Hitachi, Ltd.), 9 May 1988 (09. 05. 88), (Family: none) | 1 – 9 |
| Y | JP, A, 64-13152 (Mitsubishi Electric Corp.), 18 January 1989 (18. 01. 89), (Family: none) | 1 – 9 |
| A | JP, A, 64-48062 (Mitsui Petrochemical Industries, Ltd.), 22 February 1989 (22. 02. 89), (Family: none) | 1 – 9 |

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| October 31, 1990 (31. 10. 90) | November 13, 1990 (13. 11. 90) |
| International Searching Authority | Signature of Authorized Officer |
| Japanese Patent Office | |

Form PCT/ISA/210 (second sheet) (January 1985)